# EUROPEAN PATENT APPLICATION

(11) **EP 4 517 342 A1**
(43) Date of publication of application: **05.03.2025**
(21) Application number: 23193939.8
(22) Date of filing: 29.08.2023
(51) Int. Cl.: G01R 27/16, G01R 19/25, H02J 13/00

(54) **OPERATING METHOD AND POWER SYSTEM FOR DETECTING A GRID IMPEDANCE**

(71) Applicant: Hitachi Energy Ltd, 8050 Zürich (CH)
(72) Inventor: HASSAN, Zain, 72224 Västerås (SE); HAFNER, Ying-Jiang, 77142 Ludvika (SE); ABDALRAHMAN, Adil, 70218 Örebro (SE)
(74) Representative: Epping - Hermann - Fischer

(57) **Abstract**

In at least one embodiment, the operating method is for detecting an impedance (Zg) of a power grid (1) and comprises the following steps:
- providing a positive sequence (P) by a power converter (2) to the power grid (1), the power grid (1) is provided by the power converter (1) with an alternating current,
- injecting a negative sequence (N) by the power converter (2) into the power grid (1),
- measuring a response of the power grid (1) to the negative sequence (N), and
- online calculating the impedance (Zg) of the power grid (1) from the response.

## Description

An operating method is provided. A power system for such an operating method is also provided.

Documents US 2012/0306515 A1, CN 113 702 706 A and CN 110 620 398 A refer to power grids.

A problem to be solved is to provide a method for efficiently calculating an impedance of a power grid.

This object is achieved, inter alia, by an operating method and by a power system as defined in the independent patent claims. Exemplary further developments constitute the subject-matter of the dependent claims.

In at least one embodiment, the operating method is for detecting an impedance of a power grid, the operating method comprises the following steps, for example, in the stated order:
- providing a positive sequence by a power converter to the power grid, the power grid is provided by the power converter with an alternating current,
- injecting a negative sequence by the power converter into the power grid,
- measuring a response of the power grid to the negative sequence, and
- online calculating the impedance of the power grid from the response.

As the penetration of renewables in power grids increases and traditional synchronous generation phases out, it is critical more than ever to have robust and reliable methods for monitoring grid strength which can be estimated, for example, by determining a short-circuit capacity, SCC for short. This can be used for adaptive control of grid-connected converters and to detect islanding.

Herein an operating method for monitoring SCC by measuring the network impedance, for example, at the fundamental frequency is provided. This method is based on the injection of small negative sequence components from a power converter, like a high-voltage direct current, HVDC, converter into the power grid, although the application of this method is not limited to HVDC converters and can be applied to any power converter, like three-phase power converters. By this operating method, online impedance measurement can be provided, the online impedance measurement can be operated in a continuous or discontinuous manner, enables faster detection of network impedance and has no adverse impact on the system operation.

Hence, the operating method is for grid impedance measurement from an HVDC converter, for example.

Electrical grids are increasingly becoming dominated by power-electronics as a result of the swift uptake of renewables which brings a range of challenges such as reduction in system inertia and growing concerns regarding system security and stability. Quick and reliable estimation of the grid impedance can help address some of these challenges. It has several benefits, among them is the possibility to adapt converter control to different grid conditions including islanding, to transition seamlessly between grid-connected and islanded modes in case of grid-forming converters, and adjusting the maximum power to be transmitted from the converter's AC node to the rest of grid such that stability is ensured.

Alternatively, detecting grid impedance may be based on passive detection methods which rely on the natural dynamics of the system which are less accurate especially when system disturbances are not strong enough compared to the operating method described herein. Alternative active detection methods which create a controlled perturbation and detect impedance by recording and processing the system response are generally more accurate. However, since these methods require an intentional disturbance to be introduced into the system, the nature of the perturbation signal becomes critical in ensuring that the power system operation is unaffected. Such an active injection-based method may include single sinusoidal frequency injection based on non-characteristic harmonics such as 75 Hz, or the injection of a broad range of frequencies simultaneously such as impulse injection and pseudo-random binary injection etc. Since by principle, these methods inject harmonic frequencies, the drawbacks are reduced power quality and potential amplification of system resonances.

Other issues with alternative methods include slower detection, offline calculation which inhibits the use of network impedance in real-time for control adaptation, and injection of frequency components that can potentially disturb the power system operation. With the method described herein, these drawbacks can be avoided or reduced.

Thus, to perform adaptive control of grid-connected converters and to monitor network condition and particularly large changes such as islanding, a subject of interest is the grid impedance at the fundamental frequency. Hence, different from alternative methods, the operating method described herein proposes estimating the impedance at the fundamental frequency directly by actively injecting a small amount of fundamental negative sequence as a perturbation in the network with negligible impact to the operation of an alternating current, AC, power grid, for example. The system response to this perturbation is recorded and processed to perform an online calculation of the negative-sequence impedance of the network and since in most cases the positive and negative sequence impedances of the network are the same, it can be used to calculate a satisfactory estimate of the network SCC.

If required, as on option the information about SCC can further be used to assess the state of islanding, for example, if it goes below a threshold value, islanding can be declared which can in turn order a control mode switch of the HVDC converter, for example.

For example, the amplitude of the injected negative sequence is chosen carefully as it should be kept low enough to have minimal impact on the connected AC system and high enough to be able to cause observable perturbations that lead to accurate measurement of the impedance. The suggested amplitude of the negative sequence may be around 1% to 7% of the nominal converter bus voltage, for example.

According to at least one embodiment, the impedance of the power grid is calculated within five cycles or within three cycles of a fundamental frequency of the alternating current provided by the power converter. This time span may begin with the injecting the negative sequence.

Such relatively little time spans are enabled, for example, because a response of the power grid to the negative sequence takes place immediately and because in principle full information of the response of the power grid is contained in just one cycle. Hence, measuring the response for few or just one cycle can suffice to enable calculation of the impedance. Thus, reaction times to changes in the impedance, for example, can be decreased to a few cycles or even one cycle as well.

According to at least one embodiment, an amplitude of the negative sequence is at least 0.5% or is at least 1% or is at least 1.5% or is at least 2% of an amplitude of the positive sequence. Alternatively or additionally, the amplitude of the negative sequence is at most 10% or is at most 7% or is at most 5% or is at most 3% of the amplitude of the positive sequence. The term 'amplitude' may refer to a peak voltage and/or a peak current of the respective sequence, for example.

According to at least one embodiment, the power converter is a high-voltage direct current power converter. Thus, the power converter may convert direct current into alternating current. The term 'high-voltage' may refer to a voltage of the resulting alternating current of at least 10 kV or of at least 100 kV.

According to at least one embodiment, the measuring the response includes measuring a voltage and measuring a current of the power grid. Especially, the voltage and the current for each phase of the alternating current is measured. It is possible that only the voltage and the current is measured, for example, of each phase of the alternating current. Thus, in case of three-phase alternating current, three voltages and three currents may be measured.

By way of example, a sampling rate of the measuring the response is at least four times or is at least ten times or is at least twenty times the fundamental frequency of the positive sequence. Hence, not just effective values may be measured but the complete phasor information of all phases.

According to at least one embodiment, the measuring the response is performed at a point of common coupling, PCC, between the power grid and the power converter. As per IEEE, the PCC can be defined as the point in the power system at which the electric utility and the customer interface occurs. This point may be the customer side of a utility revenue meter.

Hence, the response on the negative sequence may be measured on output terminals of the power converter. If the voltage and the current are measured, both can be measured at the same place, like the PCC. However, for example, the current may be measured at a place different from the voltage. Thus, the voltage may be measured at the PCC while the current is measured more remote from the power converter or inside the power converter as long as it is in the same current path, for example.

According to at least one embodiment, the injecting the negative sequence and the measuring the response is done in a periodic manner. Said periodic manner may be used temporarily or continuously. For example, the negative sequence is applied with a frequency of at most 10% or of at most 5% or of at most 1% of the fundamental frequency of the alternating current. Alternatively or additionally, said frequency is at least one per hour or is at least one per minute or is at least 0.1% of the fundamental frequency of the alternating current or is at least 1% of the fundamental frequency of the alternating current.

According to at least one embodiment, the injecting the negative sequence and the measuring the response is done upon a trigger signal wherein the trigger signal is different from the aforementioned periodic manner. For example, the trigger signal is at least one of a detected change in the power grid or a deliberately activated signal. For example, the detected change may be a voltage change and/or a frequency change exceeding a set threshold. The detected change may be caused by a disturbance of the power grid and, thus, could be a disturbance-based trigger. The deliberately activated signal is, for example, a manually caused trigger signal that may be initiated by operator personal.

For example, in case of a voltage change, the threshold may be at least 1% or at least 2% and/or may be at most 20% or may be at most 10%, like 4%, of the nominal voltage of the alternating current.

It is possible that both a periodic manner and a trigger signal are used. For example, in addition to the periodic manner, a measurement is performed when a disturbance of the power grid is detected.

According to at least one embodiment, the negative sequence is injected in a pulsed manner. In other words, the negative sequence is injected only temporally, for example, in the above-stated periodic manner and/or upon the above-stated trigger signal.

According to at least one embodiment, a pulse duration of the negative sequence is at least 10 ms or is at least 20 ms or is at least 40 ms. Alternatively or additionally, said pulse duration is at most 2 s or is at most 1 s or is at most 0.4 s or is at most 0.2 s. Alternatively or additionally, said pulse duration corresponds to at least 0.5 times the fundamental frequency of the alternating current or to at least the fundamental frequency or to at least twice the fundamental frequency and/or to at most 100 times or to at most 10 times or to at most four times or to at most twice the fundamental frequency. Thus, the negative sequence may be injected for comparably short times, like just one period of the fundamental frequency.

According to at least one embodiment, the power grid is a multi-phase electrical power grid, like a three-phase electrical power grid. For example, the power grid is operated at a frequency of at least 40 Hz and/or of at most 70 Hz, corresponding to the fundamental frequency of the alternating current. By way of example, said fundamental frequency is 50 Hz or is 60 Hz.

In case of a three-phase electrical power grid, the three-phase current may be represented by the three phases abc in this order corresponding to the positive sequence. Then, the negative sequence has the order acb. The positive sequence and the negative sequence have the same number of phases and the same fundamental frequency and may have the same phase shift between the phases, and the first phase A of the positive and negative sequence may start at the same time, so that the positive and negative sequence only differ in the order of phases and in the amplitudes. All the phases abc of the positive sequence on the one hand and all the phases acb of the negative sequence on the other hand may have the same amplitude, respectively.

According to at least one embodiment, an operating voltage of the power grid is at least 100 kV and is at most 800 kV or is at most 1.2 MV. Hence, the power grid is a high-voltage power grid.

According to at least one embodiment, the measuring the response of the power grid is performed at exactly one operating point of the power grid. For example, this one point is the PCC. Thus, there is no need to perform the measuring at different points in the power grid distributed over some area.

According to at least one embodiment, the negative sequence is injected into the power grid for at most 50% or for at most 20% or for at most 10% of a time the positive sequence is provided to the power grid. Alternatively or additionally, said fraction is at least 0.01% or is at least 0.1% or is at least 1% or is at least 3%.

According to at least one embodiment, the method further comprises:
estimating a short-circuit capacity of the power grid based on the calculated impedance of the power grid.

In other words, the measured and calculated impedance of the power grid is used to calculate or at least to estimate the SCC of the power grid. Hence, the SCC can be determined online, too, with a high temporal resolution similar to the impedance.

According to at least one embodiment, at least during the measuring the response of the power grid, the calculating the impedance of the power grid is performed continuously. For example, for each sample of measured values of the response, like the currents of voltages of each phase of the alternating current, the calculating the impedance is performed.

It is possible that the calculating is synchronized with the measuring the response. For example, the calculation starts when the first measured values of the response are present, and ends with the measuring the response. The measuring the response can be synchronized with the injecting the negative sequence, that is, the measuring may start and may end together with the injecting.

A power system is additionally provided. By means of the method as indicated in connection with at least one of the above-stated embodiments, the power system is operated. Features of the power system are therefore also disclosed for the method and vice versa.

In at least one embodiment, the power system comprises a power grid, a power converter and a measurement unit, wherein
- the power converter is configured to provide a positive sequence to the power grid and to provide the power grid with an alternating current,
- the power converter is further configured to inject a negative sequence into the power grid,
- the measurement unit is configured to measure a response of the power grid to the negative sequence, and
- the measurement unit is further configured to online calculate an impedance of the power grid from the response of the power grid to the injected negative sequence.

A power system and a method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic circuit diagram of an exemplary embodiment of a power system described herein,
- Figure 2: is a schematic diagram illustrating injecting a negative sequence in a power grid of an exemplary embodiment of a power system described herein,
- Figure 3: is a schematic block diagram of an exemplary embodiment of a method for operating power systems described herein,
- Figure 4: is a schematic circuit diagram of an exemplary embodiment of a power system described herein,
- Figure 5: is a schematic representation of electric parameters of the power system of Figure 4,
- Figure 6: is a schematic circuit diagram of an exemplary embodiment of a power system described herein,
- Figure 7: is a schematic representation of electric parameters of the power system of Figure 7, and
- Figure 8: is a schematic flow diagram of an exemplary embodiment of a method for operating power systems described herein.

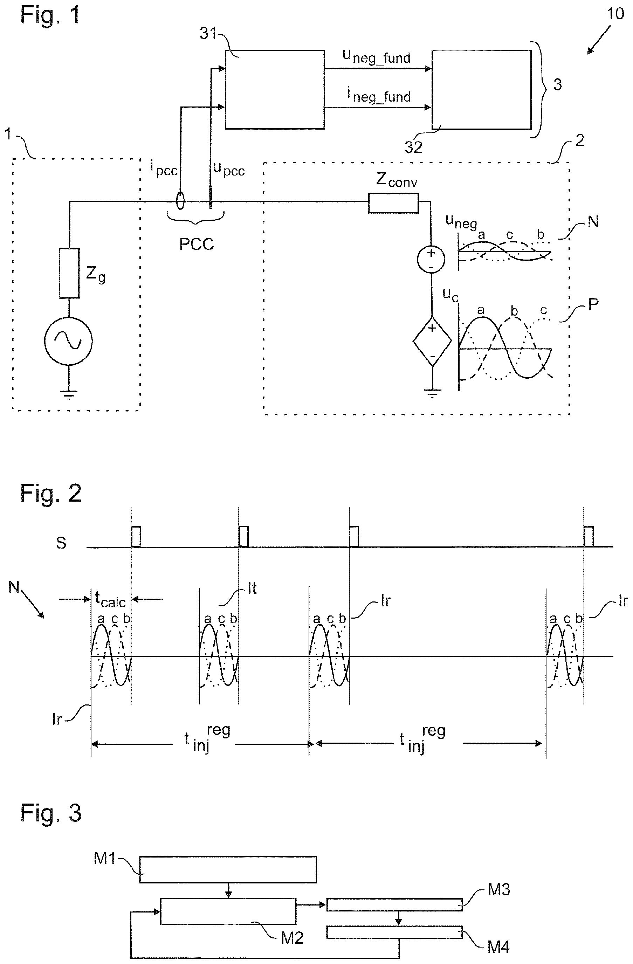

Figure 1 illustrates an example of a power system 10. The power system 10 comprises a power converter 2, like a HVDC converter. The power converter 2 provides a power grid 1 with an alternating current. Further, the power system 10 includes a measurement unit 3 coupled to the power grid 1, for example, at a PCC. The power converter 2 has an impedance Zc and the power grid 1 has an impedance Zg. The power grid 1 can be a high-voltage electrical power grid operated with a fundamental frequency of 50 Hz or 60 Hz, for example.

The power converter 2 provides the power grid 1 with a positive sequence P with three phases abc corresponding to the alternating current. Moreover, at times and intentionally the power converter 2 injects a negative sequence N with the three phases acb into the power grid 1. An amplitude of the negative sequence N is around 2% of an amplitude of the positive sequence P, for example.

The measurement unit 3 detects currents i_{pcc} and voltages u_{pcc} of all the phases of the alternating current at the PCC when the negative sequence N is injected so that a response of the power grid 1 to the negative sequence N is detected.

For example, by a fundamental negative sequence extraction unit 31 of the measurement unit 3, a voltage u_{neg_fund} and a current i_{neg_fund} at the fundamental frequency due to the injecting the negative sequence N are determined. By a impedance measurement and SCC calculation unit 32, the impedance Zg of the power grid 1 is calculated from the voltage u_{neg_fund} and the current i_{neg_fund}. Moreover, based on the impedance Zg, a short-circuit capacity, SCC, of the power grid 1 can be estimated so that a current state of the power grid 1 can be determined as well. The impedance Zg may be negative-sequence impedance.

In Figure 2, the negative sequence N is illustrated in more detail. There can be two modes of injecting the negative sequence N wherein the two modes can be combined with each other as shown in Figure 2. In a first mode, the negative sequence N is injected periodically with a regular injection periodicity of tᵢₙⱼ^{reg} which is, for example, a couple of cycles of the fundamental frequency. These parts of the negative sequence N are referred to as regular injection Ir. In a second mode, the negative sequence N is injected upon a trigger event and this part of the negative sequence N are referred to as triggered injection It.

During injecting the negative sequence N, the impedance Zg is calculated so that a calculation period t_{calc} corresponds or mostly corresponds to the time spans during which the negative sequence N is injected. After calculating the impedance Zg, the SCC is estimated. A signal S indicating an updating event of the SCC is illustrated in Figure 2 as well.

Correspondingly, the method used to estimate, for example, the SCC of the power grid 1 can include the steps as schematically shown in Figure 3.

In a method step M1, the positive sequence P is provided by the power converter 2 to the power grid 1, and the power grid 1 is provided by the power converter 1 with an alternating current. Throughout normal operation of the power system 10, the alternating current is fed into the power grid 1.

In a method step M2, the negative sequence N is injected into the power grid 1 by the power converter 2. This injection takes place only temporarily, for example.

In a method step M3, the response of the power grid 1 to the negative sequence N is measured. Step M3 may take place simultaneously or virtually simultaneously with method step M2.

Based on the measurement of the response, the impedance Zg of the power grid 1 is calculated online from the response, see method step M4. Method step M4 can also take place simultaneously or virtually simultaneously with method step M2 and/or with method step M3.

Optionally, as stated above, the method may include estimating the SCC of the power grid 1, not illustrated in Figure 3.

Based on Figures 1 to 3, an example of the method may be summarized as follows.

The negative sequence N can be injected using software-generated signals from a power converter control and is superimposed on the modulation voltage reference of the power converter 2. A voltage perturbation caused at the power converter output terminals PCC by the injected negative sequence N will in response cause a current perturbation. Both the voltage perturbation and the current response are measured at the PCC, post-processed to extract the negative sequence components which are then used to calculate the network impedance Zg.

The time taken for the impedance calculation to complete is denoted by t_{calc} during which the injection of the negative sequence N as well as the processing of impedance calculation takes place simultaneously. However, it is proposed that the output values of impedance and SCC are updated only at the end of the calculation period, compare the signal S in Figure 2 which indicates the updating.

An impedance detection algorithm can be operated in both continuous and discontinuous manner or a combination of both. In the former, the injection takes place at the regular intervals every tᵢₙⱼ^{reg} apart, for example. In the latter, the injection is triggered as a result of a change in network condition, for example, when the change in voltage magnitude or frequency exceeds a certain threshold given that there are no faults on the AC network 1. The two modes are depicted in Figure 2.

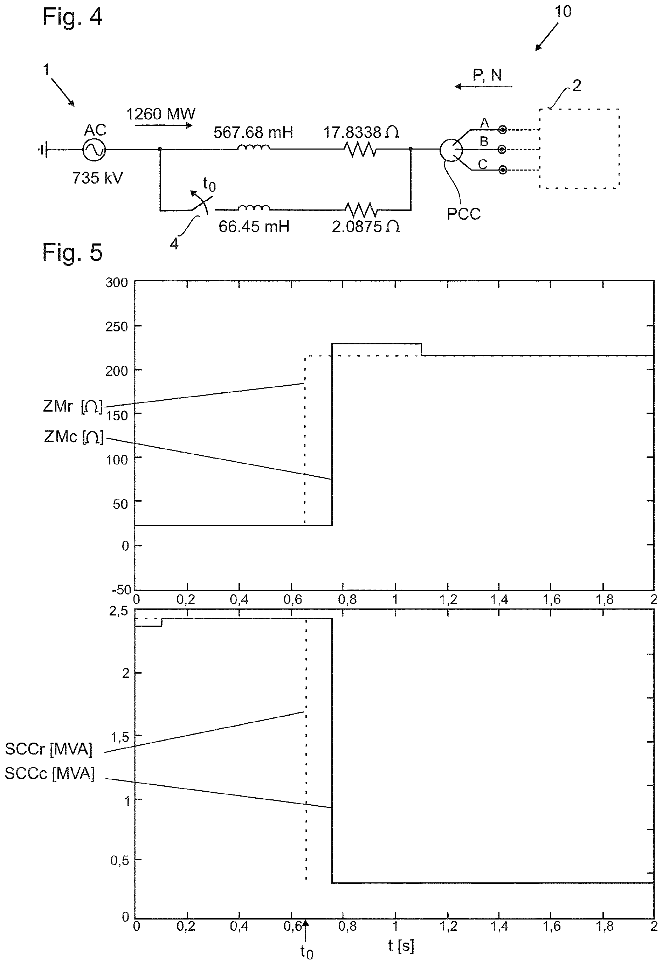

The method described herein is demonstrated using the set-up shown in Figure 4. The equivalent network impedance, shown in Figure 4, is assumed to be formed of two parallel branches with the impedances of about 0.6 H and 0.07 H; resistances of the branches are about 0.02 kΩ and 0.002 kΩ, respectively.

A change in the network condition is forced at t₀ by disconnecting the branch having the smaller impedance which results in a sudden change of SCC from about 24 GVA (high) to about 2.5 GVA (low). Disconnecting is illustrated by opening a breaker 4 in the branch having the smaller impedance. An electric power present in the power grid 1 is, for example, around 1.2 GW and the power grid 1 is operated ad 735 kV.

The results are shown in Figure 5. Illustrated is the time-dependent correct reference short-circuit capacity SCCr and reference impedance magnitude ZMr as well as the the time-dependent calculated short-circuit capacity SCCc and calculated impedance magnitude ZMc obtained with the method described herein. From Figure 5 it can be seen that the ZM and the SCC are correctly detected following the network change. At t = 0.65 s = t₀, when the breaker 4 is opened, the network suddenly changes, and the algorithm is able to detect the new value of SCC within 100 ms and with an accuracy of ≈ 93%.

Otherwise, the same as to Figures 1 to 3 may also apply to Figures 4 and 5, and vice versa.

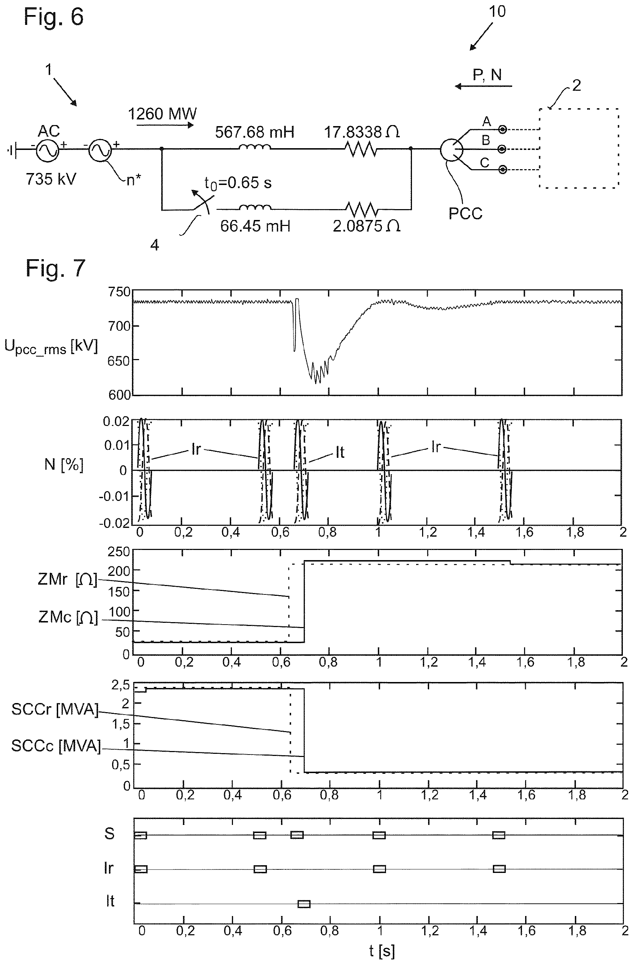

In Figure 6 it is illustrated that there is a background negative sequence n* present in the AC power system 10. The background negative sequence n* is assumed to have an amplitude of 1% of the amplitude of the positive sequence P. Thus, the background negative sequence n* and the negative sequence N are of similar intensity from point of view of the positive sequence, however, the amplitude of the negative sequence N may exceed the amplitude of the background negative sequence n*, for example, by at least a factor of 1.25 or by at least a factor of 1.5 or by at least a factor of 1.5. Optionally, the background negative sequence n* is detected by the measurement unit 3 and the amplitude of the injected negative sequence N is subsequently adjusted to allow for reliable calculation of the impedance Zg.

It can be verified from the results shown in Figure 7 that the method described herein is capable of cancelling the effect of the background negative sequence n* and providing accurate measurements of the grid impedance Zg.

Hence, see Figure 7, topmost curve, at the PCC a drop in a voltage U_{pcc_rms} from about 735 kV to about 660 kV is detected upon opening the breaker 4 at t = 0.65 s = t₀. This voltage drop results in the triggered injection It of the negative sequence N in addition to the periodical, regular injections Ir, compare the second curve and the lowermost curve. Thus, there is a sudden change in the SCC from 24,006 MVA to 2,515 MVA and also a large rise in the corresponding impedance ZM, see Figure 7, middle curves.

The measurement and the algorithm are activated within 1 ms from beginning of the voltage drop and the new impedance is calculated, and by extension the SCC values, within 50 ms with 96% to 97% accuracy. Hence, the effect of any background negative sequence n* is cancelled effectively and has negligible impact on the measurement accuracy.

Otherwise, the same as to Figures 1 to 5 may also apply to Figures 6 and 7, and vice versa.

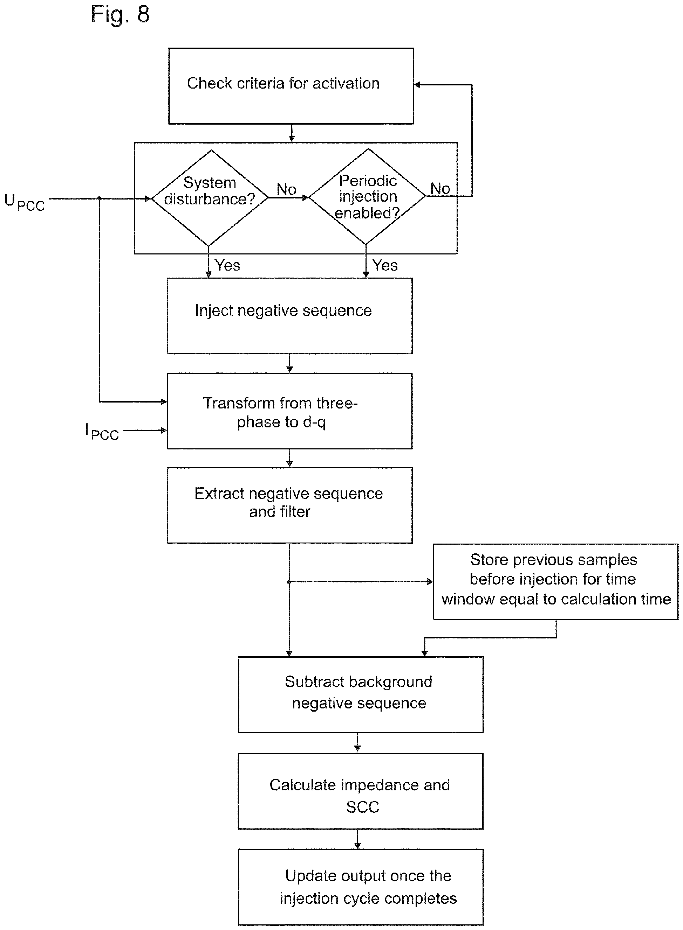

In Figure 8, a flow diagram of the operating method described herein is shown.

In a first stage of the method, it is checked if the negative sequence is to be injected, that is, if it is time for a periodic injection or if there is a system disturbance. The latter is determined, for example, by analyzing the voltage at the PCC. Correspondingly, the negative sequence is injected.

In a subsequent stage, transformation from three phases to d-q is performed taking into account the current at the PCC, and the negative sequence is extracted and filtered.

Optionally, previous samples are stored and used for subtraction of a background negative sequence.

Then, the impedance ZM and the SCC are calculated, and the output is updated once the injection cycle completes.

Otherwise, the same as to Figures 1 to 7 may also apply to Figure 8, and vice versa.

The term 'and/or' describes only an association relationship for describing associated objects and represents that three relationships may exist. For example, A and/or B may represent the following three cases: Only A exists, both A and B exist, and only B exists.

The invention described here is not restricted by the description on the basis of the exemplary embodiments. Rather, the invention encompasses any new feature and also any combination of features, which includes in particular any combination of features in the patent claims, even if this feature or this combination itself is not explicitly specified in the patent claims or exemplary embodiments.

### List of Reference Signs

- 1: power grid
- 2: power converter
- 3: measurement unit
- 31: fundamental negative sequence extraction unit
- 32: impedance measurement and SCC calculation unit
- 4: circuit breaker
- 10: power system
- i: current
- Ir: regular injection of the negative sequence
- It: triggered injection of the negative sequence
- M: method step
- N: provided negative sequence
- n*: background negative sequence
- P: provided positive sequence
- PCC: point of common coupling
- S: signal indicating updating the short-circuit capacity
- SCCr: reference short-circuit capacity
- SCCc: calculated short-circuit capacity
- t: time
- u: voltage
- Zc: impedance of the power converter
- Zg: impedance of the grid
- ZMr: reference impedance magnitude
- ZMc: calculated impedance magnitude

## Claims

1. An operating method for detecting an impedance (Zg) of a power grid (1) comprising the following steps:
- providing a positive sequence (P) by a power converter (2) to the power grid (1), the power grid (1) is provided by the power converter (1) with an alternating current,
- injecting a negative sequence (N) by the power converter (2) into the power grid (1),
- measuring a response of the power grid (1) to the negative sequence (N), and
- online calculating the impedance (Zg) of the power grid (1) from the response.

2. The method according to the preceding claim,
wherein the impedance (Zg) of the power grid (1) is calculated within five cycles of a fundamental frequency of the alternating current, from a beginning of the injecting the negative sequence (N).

3. The method according to any one of the preceding claims, wherein an amplitude of the negative sequence (N) is at least 1% and is at most 7% of an amplitude of the positive sequence (P) .

4. The method according to any one of the preceding claims, wherein the power converter (2) is a high-voltage direct current power converter.

5. The method according to any one of the preceding claims, wherein the measuring the response includes measuring a voltage and measuring a current of the power grid (1) for each phase of the alternating current.

6. The method according to any one of the preceding claims, wherein the measuring the response is performed at a point of common coupling (PCC) between the power grid (1) and the power converter (2).

7. The method according to any one of the preceding claims, wherein the injecting the negative sequence (N) and the measuring the response is done at least temporarily in a periodic manner.

8. The method according to any one of the preceding claims, wherein the injecting the negative sequence (N) and the measuring the response is done upon a trigger signal, wherein the trigger signal is at least one of a detected voltage change in the power grid (1) or a deliberately activated signal.

9. The method according to any one of the preceding claims, wherein the negative sequence (N) is injected in a pulsed manner,
wherein a pulse duration of the negative sequence is at least 40 ms and is at most 0.4 s.

10. The method according to any one of the preceding claims, wherein the power grid (1) is a three-phase electrical power grid operated at a frequency of at least 40 Hz and of at most 70 Hz,
wherein an operating voltage of the power grid (1) is at least 100 kV and is at most 800 kV.

11. The method according to any one of the preceding claims, wherein the measuring the response of the power grid (1) is performed at one operating point of the power grid (1).

12. The method according to any one of the preceding claims, wherein the negative sequence (N) is injected into the power grid (1) for at most 20% of a time the positive sequence (P) is provided to the power grid (1).

13. The method according to any one of the preceding claims, wherein the method further comprises:
estimating a short-circuit capacity of the power grid (1) based on the calculated impedance (Zg) of the power grid (1).

14. The method according to any one of the preceding claims, wherein at least during the measuring the response of the power grid (1), the calculating the impedance (Zg) of the power grid (1) is performed continuously.

15. A power system (10) comprising a power grid (1), a power converter (2) and a measurement unit (3), wherein
- the power converter (2) is configured to provide a positive sequence (P) to the power grid (1) and to provide the power grid (1) with an alternating current,
- the power converter (2) is configured to inject a negative sequence (N) into the power grid (1),
- the measurement unit (3) is configured to measure a response of the power grid (1) to the negative sequence (N), and
- the measurement unit (3) is configured to online calculate an impedance (Zg) of the power grid (1) from the response of the power grid (1) to the negative sequence (N).
